# FASCICULE DE BREVET EUROPEEN

(11) **EP 3 163 739 B1**
(45) Date de publication et mention de la délivrance du brevet: **26.09.2018**
(21) Numéro de dépôt: 16194966.4
(22) Date de dépôt: 21.10.2016
(51) Int. Cl.: H02N 2/18

(54) **SYSTÈME DE CONVERSION D'ÉNERGIE THERMIQUE EN ÉNERGIE ÉLECTRIQUE**
SYSTEM ZUR UMWANDLUNG VON WÄRMEENERGIE IN ELEKTRISCHE ENERGIE
THERMAL TO ELECTRICAL ENERGY CONVERTER SYSTEM

(30) Priorité: 26.10.2015 FR 1560185
(43) Date de publication de la demande: 03.05.2017
(73) Titulaire: STMicroelectronics (Crolles 2) SAS, 38920 Crolles (FR)
(72) Inventeur: ARNAUD, Arthur, 38000 GRENOBLE (FR); BOUGHALEB, Jihane, 38000 GRENOBLE (FR); MONFRAY, Stéphane, 38320 EYBENS (FR); SKOTNICKI, Thomas, 38920 CROLLES-MONTFORT (FR)
(74) Mandataire: Casalonga

(56) Documents cités:
- EP-A1- 2 309 560
- EP-A1- 2 312 154
- WO-A1-2013/007693
- WO-A2-2007/087383
- US-A1- 2008 100 181
- US-A1- 2013 257 219
- US-A1- 2015 300 328

## Description

Des modes de réalisation de l'invention concernent les transducteurs thermoélectriques, en particulier dans le cadre de la récupération de l'énergie thermique produite par des circuits électroniques en fonctionnement.

Il est envisagé de récupérer cette énergie thermique pour la convertir au moins en partie en énergie électrique.

Il existe des éléments sensibles à la température permettant de convertir l'énergie thermique en énergie mécanique, notamment grâce à des structures offrant une très grande aptitude à la déformation sous l'effet de la température. Il peut s'agir par exemple de lames bimétallique (ou bilames). Un bilame comprend deux lames (ou membranes) de métaux d'alliages différents à coefficient de dilatation thermique différents, souples, soudées ou collées face à face l'une contre l'autre.

Dans la suite Ksup et Kinf désignent respectivement les coefficients thermiques des membranes du bilame, avec Ksup > Kinf, tandis que MKsup et MKinf désignent respectivement les membranes correspondantes, dites membrane de forte expansion et membrane de faible expansion.

Lorsqu'un bilame est échauffé, la membrane de forte expansion MKsup à tendance à se dilater plus que la membrane de faible expansion MKinf, et le bilame se courbe suivant un rayon de courbure dans la direction de la membrane MKsup vers la membrane MKinf.

A l'inverse, lorsqu'un bilame est refroidi, la membrane de forte expansion MKsup à tendance à se contracter plus que la membrane de faible expansion MKinf, et le bilame se courbe suivant un rayon de courbure dans la direction de la membrane MKinf vers la membrane MKsup.

Ainsi, si on échauffe et refroidit le bilame de manière répétée, la courbure se retourne autant de fois. Les retournements de la courbure se produisent selon un claquage, le bilame passant brutalement d'une première position stable à une seconde position stable. On parle alors de « bistabilité ».

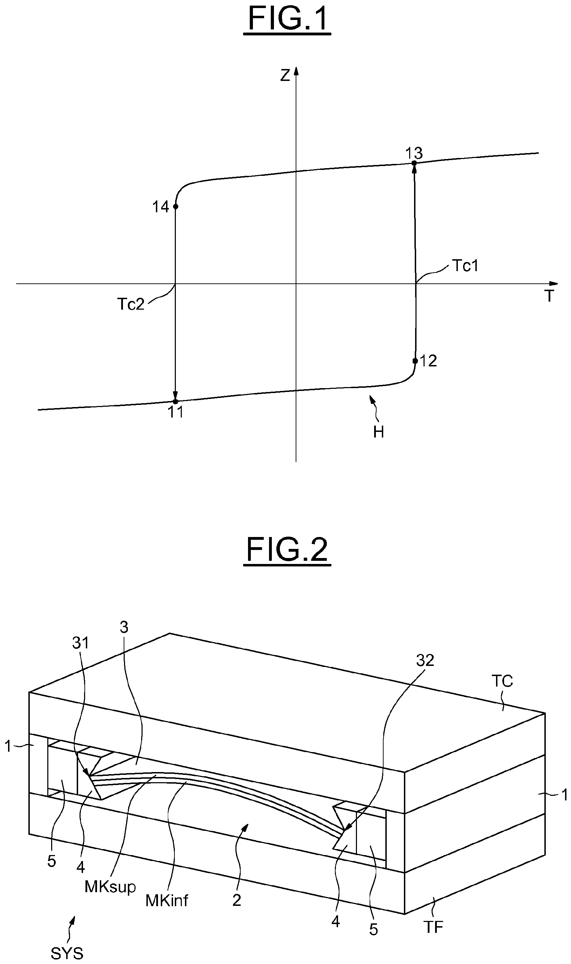

Ainsi lorsqu'on place un bilame entre une source chaude et une source froide, il oscille d'une position stable à l'autre de manière cyclique. Un tel cycle est illustré par la figure 1.

La courbe H représente l'évolution de la position verticale Z du milieu de la courbure du bilame par rapport à une position médiane en fonction de la température T, et forme un cycle d'hystérésis. Lorsque l'on échauffe le bilame à partir d'une première position stable 11, la courbure reste sensiblement constante jusqu'à une première température de claquage Tc1, représentée au point 12.

A la température Tc1, le passage du point 12 au point 13 se traduit par le retournement brutal de la courbure. Au point 13, le bilame prend alors sa seconde position stable.

Le passage du point 13 au point 14 correspond à une diminution de la température du bilame, la courbure restant sensiblement constante jusqu'au point 14 à une seconde température de claquage Tc2.

A la température Tc2, le passage du point 14 au point 11 se traduit par le retournement brutal de la courbure. Au point 11, le bilame a repris sa première position stable.

A chaque passage d'une position stable à l'autre, la courbure diminue puis augmente. La diminution de la courbure de l'arc formé par le bilame entraine naturellement une élongation de la corde, et une force longitudinale sortante est ainsi générée aux extrémités du bilame lors de chaque claquage.

Il existe aussi des dispositifs de conversion d'énergie mécanique en énergie électrique, par exemple mettant en oeuvre les propriétés des matériaux piézoélectriques. Un matériau piézoélectrique est un matériau qui, lorsqu'il est soumis à une déformation mécanique, génère une tension électrique.

Il existe dans l'état de la technique des systèmes de conversion d'énergie thermique en énergie électrique combinant un bilame et un élément piézoélectrique. Le bilame est généralement placé entre une source chaude et une source froide, alternant d'une courbure à l'autre de manière cyclique, et l'élément piézoélectrique est généralement contraint en torsion, étant notamment désigné dans la technique par « piézoélectrique de type 3-1 ».

Un tel système est notamment décrit dans la demande de brevet US 2015/0115769 A1, dans lequel l'élément piézoélectrique est fixé en porte à faux sur le bilame. L'élément piézoélectrique suspendu entre en vibration lors des changements de position du bilame.

US 2015/0300328 A1 décrit un autre système de l'état de la technique, qui présente un élément piézoélectrique disposé contre l'une des sources de température. Lors d'un claquage, une partie de l'énergie cinétique du bilame est transférée à l'élément piézoélectrique par choc mécanique.

WO 2007/087383 A1 divulgue un dispositif de récupération d'énergie, comprenant un composant ferromagnétique et un ensemble mécanique à mémoire de forme structuré pour avoir un état de mouvement transitoire dû au fait que ledit composant ferromagnétique satisfait à des première et seconde conditions de température, dans lequel un transducteur électromécanique est agencé pour produire de l'énergie électrique au cours dudit mouvement transitoire.

US 2008/01100181 A1 divulgue un générateur comprenant une poutre flexible configurée pour exercer une contrainte de compression sur un élément piézocéramique générant un signal de sortie électrique, la contrainte provenant d'un élément mécanique à mouvement de va-et-vient positionné à un point médian de la poutre flexible.

Les réalisations actuelles présentent de nombreux inconvénients, notamment des efficacités de transfert thermique et mécanique limitées, une répercussion indésirable de la température sur l'efficacité piézoélectrique, une diffusion de l'énergie thermique dans l'élément piézoélectrique, une fréquence de travail faible, des pertes d'énergie mécanique dans le support, ou encore des problèmes structurels de positionnement et d'encapsulation des éléments du système.

Selon un mode de réalisation, il est proposé un système de conversion d'énergie thermique en énergie électrique combinant une lame bimétallique et un élément piézoélectrique présentant notamment de meilleures efficacités de transfert et de conversion d'énergie, un mode opératoire optimisé et une fabrication simple.

Selon un aspect il est proposé un système de conversion d'énergie thermique en énergie électrique, comprenant
un châssis,
au moins un élément sensible à la température maintenu dans le châssis par deux de ses extrémités entre une source chaude et un source froide,
au moins un élément piézoélectrique disposé entre au moins une partie du châssis et au moins une première desdites deux extrémités dudit au moins un élément sensible à la température,
ledit au moins un élément sensible à la température étant configuré pour se déformer cycliquement entre deux états sous l'action du gradient thermique entre la source chaude et la source froide tout en exerçant une contrainte lors de sa déformation cyclique sur ledit au moins un élément piézoélectrique par l'intermédiaire de ladite au moins une première extrémité.

Ainsi, cette configuration permet de réduire le nombre d'éléments intermédiaires lors de la conversion d'énergie thermique en énergie mécanique et lors de la conversion d'énergie mécanique en énergie électrique. Cela se traduit par une meilleure efficacité globale du système.

En effet, contrairement aux exemples de l'état de la technique présentés ci-avant, dans cette configuration il n'y a pas d'élément diffusant la chaleur entre les sources de température et l'élément sensible à la température. De même, l'élément piézoélectrique étant en liaison directe avec une extrémité de l'élément sensible à la température, la contrainte mécanique est directement appliquée à l'élément piézoélectrique lors de chaque claquage.

Ladite contrainte sur l'élément piézoélectrique peut être une contrainte en compression.

En effet, le claquage d'un bilame génère une contrainte mécanique longitudinale à ses extrémités, provoquant, dans cette configuration, une compression du ou des éléments piézoélectriques.

Selon un mode de réalisation, l'élément sensible à la température est, dans au moins une de ses formes, en contact avec l'une ou l'autre des sources chaude ou froide, ou en est très proche.

Cela permet d'optimiser les échanges thermiques entre l'élément sensible à la température et au moins l'une des sources de chaleur.

Ainsi la température de l'élément sensible à la température atteint rapidement les températures de claquage, et la fréquence de répétition du cycle de déformation est optimisée.

Selon un mode de réalisation l'élément sensible à la température comprend une lame bimétallique, ou bilame.

La membrane de forte expansion du bilame peut comprendre un alliage de fer-nickel-chrome, par exemple de stoechiométrie Fe 75% - Ni 22% - Cr 3%, connu sous le nom de NC₄. La membrane de faible expansion du bilame peut comprendre un alliage de fer-nickel, par exemple de stoechiométrie Fe 64% - Ni 36%, connu sous le nom d'Invar.

Un bilame formé par le couple de matériaux NC₄-Invar présente des propriétés avantageuses en matière d'efficacité de conversion de l'énergie thermique en énergie électrique en raison d'un coefficient de couplage thermo-mécanique élevé, en matière de puissance mécanique délivrée, ainsi qu'une facilité de mise en forme et de dimensionnement des caractéristiques de bistabilité (températures de claquage, amplitude...).

L'élément sensible à la température peut être poinçonné en son centre.

En effet, un poinçon ou une marque, formant par exemple une arête circulaire sur la surface de la lame bimétallique, donne une courbure initiale au bilame et permet notamment d'améliorer l'effet de claquage, et ainsi d'optimiser le cycle d'hystérésis de la lame bimétallique en fonction des besoins (températures de claquage, amplitude...).

Selon un mode de réalisation, au moins un élément de fixation est disposé entre ladite au moins une première extrémité de l'élément sensible à la température et l'élément piézoélectrique, et est configuré pour maintenir l'élément sensible à la température par ladite au moins une première extrémité.

Un tel élément de fixation permet, en sus de maintenir en bonne position l'élément sensible à la température, d'éviter un contact direct entre l'élément piézoélectrique et l'élément sensible à la température, protégeant l'élément piézoélectrique par exemple d'une usure mécanique ou d'un transfert thermique non souhaité.

De plus, un tel élément de fixation permet d'appliquer la contrainte de manière homogène sur une surface avantageuse de l'élément piézoélectrique.

L'élément de fixation peut être préférentiellement d'une forme assurant à la fois un bon maintien de l'élément sensible à la température, et imposant un minimum de contraintes mécaniques lors des changements de forme.

Selon un mode de réalisation, l'élément piézoélectrique comprend un empilement de couches d'un matériau piézoélectrique, par exemple du PZT, formant un empilement de capacités piézoélectriques mises en parallèle, et est généralement désigné par l'homme du métier sous le vocable « stack piézoélectrique 3-3 ».

Lorsqu'un stack piézoélectrique 3-3 est contraint en compression, un champ électrique est généré dans la direction de la contrainte et les valeurs capacitives des couches empilées diminuent. Cela a pour conséquence un couplage électromécanique important dans cette direction et se traduit par une conversion efficace de l'énergie mécanique en énergie électrique.

A titre d'exemple, les stacks piézoélectriques 3-3 présentent un facteur de couplage électromécanique supérieur aux piézoélectriques 3-1, environ 0,75 contre respectivement environ 0,39, ce qui équivaut respectivement à 57% de l'énergie mécanique transformée en énergie électrique contre 15%.

Selon un mode de réalisation, l'élément piézoélectrique est isolé du transfert de chaleur entre ladite source chaude et ladite source froide.

Une isolation thermique permet de s'affranchir d'effets indésirables dus à la température sur l'élément piézoélectrique, et ainsi les autres transferts thermiques peuvent être optimisés sans répercussion négative sur la collecte d'énergie.

Par exemple, ledit châssis peut être thermiquement isolant, permettant d'isoler l'élément piézoélectrique du transfert de chaleur et aussi de maintenir un gradient thermique élevé à l'intérieur du système.

Selon un autre aspect, il est proposé un dispositif de récupération d'énergie, comprenant un système de conversion d'énergie tel que défini ci-avant, et un moyen de stockage d'énergie couplé à l'élément piézoélectrique et configuré pour stocker l'énergie produite par l'élément piézoélectrique.

Un tel dispositif peut notamment être utilisé en tant que source d'énergie de systèmes autonomes à très basse consommation énergétique.

D'autres avantages et caractéristiques de l'invention apparaîtront à l'examen de la description détaillée de modes de réalisation, nullement limitatifs, et des dessins annexés sur lesquels :
- La figure 1 précédemment décrite illustre un cycle d'hystérésis de la position d'un bilame en fonction de la température, et,
- Les figures 2 à 6 illustrent schématiquement différents modes de réalisation d'un système de conversion d'énergie selon l'invention.
- La figure 7 illustre schématiquement un dispositif de récupération d'énergie alimentant une charge.

Les figures 2, 3 et 4 représentent respectivement une vue en perspective et des vues de côté d'une réalisation d'un système SYS selon l'invention, les éléments communs auxdites figures comportant les mêmes références.

Dans cette réalisation, une source chaude TC et une source froide TF sont assemblées en regard l'une de l'autre par un châssis thermiquement isolant 1, en formant un espace libre 2 entre elles.

Une lame bimétallique ou bilame 3, de forme rectangulaire et courbée dans sa longueur, est placée dans l'espace libre 2. La lame bimétallique 3 comprend une membrane de forte expansion MKsup de coefficient de dilatation thermique Ksup et une membrane de faible expansion MKinf de coefficient de dilatation thermique Kinf accolées face à face.

La lame bimétallique 3 est maintenue en appui sur les arêtes 31, 32 de ses extrémités longitudinales par deux éléments de fixation 4, en appui et/ou fixés sur des empilements piézocomposite 5 de type 3-3, eux-mêmes appuyés et/ou fixés contre la face du châssis 1 dirigée vers l'espace 2.

Les éléments de fixation 4 sont thermiquement isolants et comportent ici une forme de rainure à section triangulaire dans laquelle les arêtes 31, 32 de la lame 3 viennent s'encastrer, la lame 3 étant alors correctement maintenue tout en restant libre de se retourner.

La face opposée à la rainure des éléments de fixation 4 est plane et sa surface correspond à une surface avantageusement active des empilements piézocomposite 5.

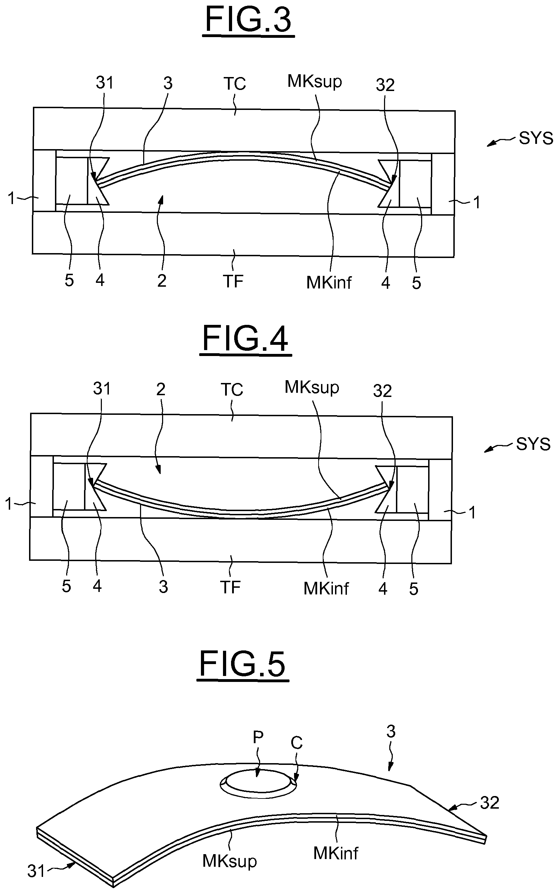

Dans les figures 2 et 3, la lame bimétallique 3 est représentée dans une première position stable, en contact avec la source chaude TC, et correspond à une position entre les points 11 et 12 du cycle d'hystérésis H représenté en figure 1.

Dans la figure 4, la lame 3 est dans sa seconde position stable, en contact avec la source froide TF, et correspond à une position entre les points 13 et 14 du cycle d'hystérésis H représenté en figure 1.

A titre d'exemple, les températures des sources chaudes TC et froide TF peuvent être comprises dans une large gamme allant de -40°C à 300°C. Les températures de claquages Tc1 et Tc2 peuvent avoir toute valeur dans cette gamme, avec Tc1>Tc2, et sont fixées par le choix des matériaux du bilame, des dimensions du bilame, et de la courbure initiale donnée au bilame.

Pour un bilame donné avec des températures de claquage Tc1 et Tc2 la condition de fonctionnement est que la température de la source froide TF soit inférieure à la température de claquage Tc2 et la température de source chaude TC soit supérieure à la température de claquage Tc1

D'autre part, les sources chaude TC et froide TF ont été représentées sous la forme de parallélépipèdes réguliers, mais on peut envisager toute forme, par exemple des surfaces concaves ou convexes, de même, la rainure des éléments de fixation 4 peut être d'une autre forme, par exemple de section courbe.

La figure 5 représente un mode de réalisation de la lame bimétallique 3 comprenant un poinçon P en son milieu. Ce poinçon P crée une pliure circulaire C sur la surface de la lame bimétallique 3 dont la géométrie permet notamment de contrôler les températures de claquage et le cycle d'hystérésis.

La lame bimétallique 3 peut être de dimensions macroscopiques, de l'ordre du cm², et les membranes peuvent comprendre dans ce cas un alliage Fer-Nickel de différentes stoechiométries, comme par exemple l'Invar (Fe 64% - Ni 36%). Ces alliages peuvent également contenir du chrome et/ou du manganèse, augmentant leurs coefficients de dilatation thermique, comme par exemple le NC₄ (Fe 75% - Ni 22% - Cr 3%), ou encore les alliages (Mn 72% - Cu 18% - Ni 10%), (Fe 74% - Ni 20% - Mn 6%). D'autres métaux peuvent être utilisés, comme par exemple l'aluminium ou le cuivre.

La lame 3 présente une épaisseur de l'ordre de quelques dixièmes de millimètre, afin de minimiser son volume de manière à accélérer l'échauffement et le refroidissement de sa masse, et donc d'augmenter la fréquence de répétition du cycle de déformations.

La lame bimétallique peut également être de dimensions micrométriques, et les membranes peuvent être réalisées en technologie couches minces, associant des matériaux tels que Si-Al, SiO₂-Al, Si-Au, SiO₂-Au, SiPb par exemple, sur des épaisseurs de quelques dizaines de micromètres.

Cela étant, l'élément sensible à la température peut également être formé en alliage à mémoire de forme ayant mémorisé deux formes. Les alliages à mémoire de forme peuvent être par exemple en Cu-Zn, Cu-Zn-Al, Cu-Ni-Al, Au-Cd, Fe-Pt.

Dans tous les cas, la stoechiométrie des matériaux est choisie en fonction de la plage de températures d'utilisation fixée par les sources chaude et froide.

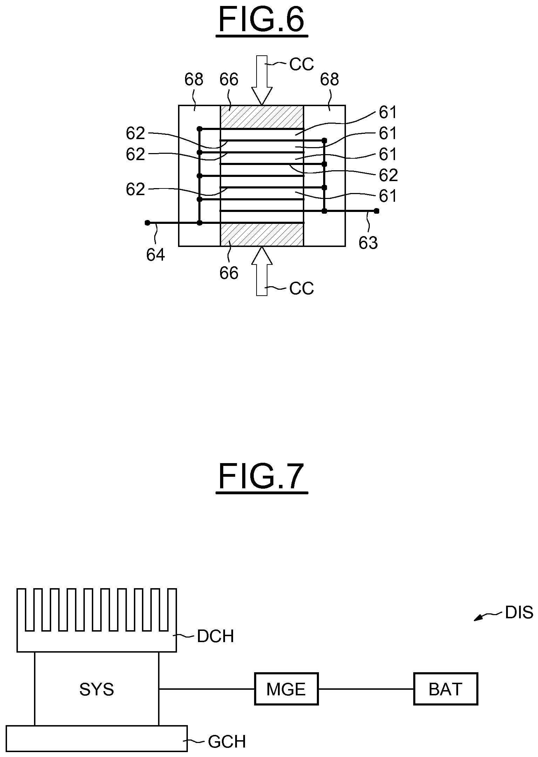

La figure 6 représente une vue en coupe d'un stack piézoélectrique 3-3, comprenant un empilement de couches 61 d'un matériau piézoélectrique. Le matériau piézoélectrique peut être par exemple du PZT, ou un piézocomposite comprenant un matériau piézoélectrique et un matériau non-piézoélectrique.

Chaque couche 61 est connectée aux couches voisines par des électrodes 62, formant autant de capacités piézoélectriques.

Les électrodes 62 sont reliées alternativement à des noeuds 63 et 64 constituant alors les bornes de la capacité piézoélectrique équivalente aux capacités piézoélectriques de chaque couche mises en parallèle.

Les extrémités de l'empilement sont habituellement protégées par des interfaces en céramique 66, et l'empilement est encapsulé radialement par un revêtement isolant 68.

Des flèches CC représentent une contrainte en compression appliquée sur le stack piézoélectrique 3-3.

Lorsque la contrainte CC est suffisamment importante pour introduire une déformation du stack piézoélectrique 3-3, une tension électrique est générée entre chaque électrode, et les électrodes de chaque capacité piézoélectrique se rapprochent, faisant diminuer la valeur de ladite capacité équivalente.

La figure 7 représente un dispositif DIS de récupération d'énergie utilisée comme source d'énergie pour alimenter une charge BAT.

Le dispositif DIS comprend un système SYS tel que décrit ci-avant, dont la source chaude TC est en contact ou proche d'un générateur de chaleur GCH et dont la source froide TF est en contact ou proche d'un dissipateur de chaleur DCH.

Le générateur de chaleur GCH peut être par exemple un élément chaud d'un circuit électronique en fonctionnement, tel qu'un microcontrôleur, ou toute autre source chaude.

Le dissipateur de chaleur peut être par exemple un radiateur ou toute autre source froide.

Le gradient thermique entre les sources chaude TC et froide TF, de températures respectivement imposées par le générateur de chaleur GCH et le dissipateur de chaleur DCH, permet au système SYS de générer de l'énergie électrique.

Les éléments piézoélectriques du système SYS sont connectés à un moyen de stockage d'énergie BAT, par exemple un condensateur, apte à stocker l'énergie électrique, via un moyen de gestion de l'énergie MGE configuré pour optimiser le chargement du moyen BAT à partir des signaux de tension produits par les éléments piézoélectriques 3 du système SYS.

## Revendications

1. Système de conversion d'énergie thermique en énergie électrique (SYS), comprenant un châssis (1), au moins un élément sensible à la température (3) maintenu dans le châssis (1) par deux de ses extrémités (31, 32) entre une source chaude (TC) et une source froide (TF), au moins un élément piézoélectrique (5) disposé entre au moins une partie du châssis (1) et au moins une première desdites deux extrémités (31, 32) dudit au moins un élément sensible à la température (3), ledit au moins un élément sensible à la température (3) étant configuré pour se déformer cycliquement entre deux états sous l'action du gradient thermique entre la source chaude (TC) et la source froide (TF) tout en exerçant une contrainte lors de sa déformation cyclique sur ledit au moins un élément piézoélectrique (5) par l'intermédiaire de ladite au moins une première extrémité.

2. Système de conversion d'énergie selon la revendication 1, dans lequel l'élément sensible à la température (3) est, dans au moins une de ses formes, en contact avec l'une ou l'autre des sources chaude (TC) ou froide (TF).

3. Système de conversion d'énergie selon les revendications 1 ou 2, dans lequel l'élément sensible à la température (3) comprend une lame bimétallique.

4. Système de conversion d'énergie selon l'une quelconque des revendications précédentes, dans lequel l'élément sensible à la température (3) est poinçonné en son centre.

5. Système de conversion d'énergie selon l'une quelconque des revendications précédentes, comprenant en outre au moins un élément de fixation (4), disposé entre ladite au moins une première extrémité de l'élément sensible à la température (3) et l'élément piézoélectrique (5), et configuré pour maintenir l'élément sensible à la température (3) par ladite au moins une extrémité.

6. Système de conversion d'énergie selon l'une quelconque des revendications précédentes, dans lequel l'élément piézoélectrique (5) comprend un empilement de capacités piézoélectriques mises en parallèle.

7. Système de conversion d'énergie selon l'une quelconque des revendications précédentes, dans lequel ladite contrainte sur l'élément piézoélectrique (5) est une contrainte en compression.

8. Système de conversion d'énergie selon l'une quelconque des revendications précédentes, dans lequel l'élément piézoélectrique (5) est isolé du transfert de chaleur entre ladite source chaude (TC) et ladite source froide (TF).

9. Dispositif de récupération d'énergie, comprenant un système de conversion d'énergie (SYS) selon l'une quelconque des revendications précédentes, un moyen de stockage d'énergie (BAT) couplé à l'élément piézoélectrique (5) et configuré pour stocker l'énergie produite par l'élément piézoélectrique (5).

## Patentansprüche

1. System zur Umwandlung von Wärmeenergie in elektrische Energie (SYS), umfassend einen Rahmen (1), mindestens ein temperaturempfindliches Element (3), das in dem Rahmen (1) an seinen beiden Enden (31, 32) zwischen einer Wärmequelle (TC) und einer Kältequelle (TF) gehalten wird, mindestens ein piezoelektrisches Element (5), das zwischen mindestens einem Teil des Rahmens (1) und mindestens einem ersten der beiden Enden (31, 32) des mindestens einen temperaturempfindlichen Elements (3) angeordnet ist, wobei das mindestens eine temperaturempfindliche Element (3) ausgelegt ist, sich zyklisch zwischen zwei Zuständen durch die Wirkung des Wärmegradienten zwischen der Wärmequelle (TC) und der Kältequelle (TF) zu verformen, wobei gleichzeitig eine Belastung bei seiner zyklischen Verformung auf das mindestens eine piezoelektrische Element (5) über das mindestens eine erste Ende ausgeübt wird.

2. System zur Umwandlung von Energie nach Anspruch 1, wobei das temperaturempfindliche Element (3) in mindestens einer seiner Formen mit der einen oder der anderen von der Wärme- (TC) oder Kältequelle (TF) in Kontakt steht.

3. System zur Umwandlung von Energie nach Anspruch 1 oder 2,
wobei das temperaturempfindliche Element (3) eine Bimetalllamelle umfasst.

4. System zur Umwandlung von Energie nach einem der vorhergehenden Ansprüche,
wobei das temperaturempfindliche Element (3) in seinem Zentrum gestanzt ist.

5. System zur Umwandlung von Energie nach einem der vorhergehenden Ansprüche,
ferner umfassend mindestens ein Befestigungselement (4), das zwischen dem mindestens einen ersten Ende des temperaturempfindlichen Elements (3) und dem piezoelektrischen Element (5) angeordnet ist und ausgelegt ist, das temperaturempfindliche Element (3) durch das mindestens eine Ende zu halten.

6. System zur Umwandlung von Energie nach einem der vorhergehenden Ansprüche,
wobei das piezoelektrische Element (5) einen Stapel piezoelektrischer Kapazitäten umfasst, die parallel angeordnet sind.

7. System zur Umwandlung von Energie nach einem der vorhergehenden Ansprüche,
wobei die Belastung auf das piezoelektrische Element (5) eine Druckbelastung ist.

8. System zur Umwandlung von Energie nach einem der vorhergehenden Ansprüche,
wobei das piezoelektrische Element (5) gegen den Wärmetransfer zwischen der Wärmequelle (TC) und der Kältequelle (TF) isoliert ist.

9. Vorrichtung zur Gewinnung von Energie, umfassend ein System zur Umwandlung von Energie (SYS) nach einem der vorhergehenden Ansprüche, und ein Mittel zum Speichern von Energie (BAT), das mit dem piezoelektrischen Element (5) gekoppelt ist und ausgelegt ist, die von dem piezoelektrischen Element (5) erzeugte Energie zu speichern.

## Claims

1. System for converting thermal energy into electrical power (SYS), comprising a frame (1), at least one temperature-sensitive element (3) held in the frame (1) by two of its ends (31, 32) between a heat source (TC) and a cold source (TF), and at least one piezoelectric element (5) placed between at least one portion of the frame (1) and at least a first of said two ends (31, 32) of said at least one temperature-sensitive element (3), said at least one temperature-sensitive element (3) being configured to deform cyclically between two states under the action of the thermal gradient between the heat source (TC) and the cold source (TF) while exerting a stress during its cyclic deformation on said at least one piezoelectric element (5) via said at least one first end.

2. Energy-converting system according to Claim 1, in which the temperature-sensitive element (3) makes, when it is at least one of its shapes, contact with one or other of the heat source (TC) and cold source (TF).

3. Energy-converting system according to either of Claims 1 and 2, in which the temperature-sensitive element (3) comprises a bimetallic strip.

4. Energy-converting system according to any one of the preceding claims, in which the temperature-sensitive element (3) is stamped in its centre.

5. Energy-converting system according to any one of the preceding claims, furthermore comprising at least one fastening element (4), placed between said at least one first end of the temperature-sensitive element (3) and the piezoelectric element (5), and configured to hold the temperature-sensitive element (3) by said at least one end.

6. Energy-converting system according to any one of the preceding claims, in which the piezoelectric element (5) comprises a stack of piezoelectric capacitors connected in parallel.

7. Energy-converting system according to any one of the preceding claims, in which said stress on the piezoelectric element (5) is a compressive stress.

8. Energy-converting system according to any one of the preceding claims, in which the piezoelectric element (5) is insulated from the transfer of heat between said heat source (TC) and said cold source (TF) .

9. Energy-recovering device, comprising an energy-converting system (SYS) according to any one of the preceding claims, and power-storing means (BAT) coupled to the piezoelectric element (5) and configured to store the power produced by the piezoelectric element (5).
